(19) Europäisches Patentamt / European Patent Office / Office européen des brevets

(11) **EP 4 700 401 A1**

(12) **EUROPEAN PATENT APPLICATION**
published in accordance with Art. 153(4) EPC

(43) Date of publication:
**25.02.2026 Bulletin 2026/09**

(21) Application number: **24811213.8**

(22) Date of filing: **09.01.2024**

(51) International Patent Classification (IPC):
**G01R 31/367** (2019.01)   **G01R 31/389** (2019.01)
**G01R 31/382** (2019.01)   **G01R 31/374** (2019.01)
**G01R 31/36** (2020.01)

(52) Cooperative Patent Classification (CPC):
Y02E 60/10

(86) International application number:
**PCT/KR2024/000428**

(87) International publication number:
**WO 2024/242274 (28.11.2024 Gazette 2024/48)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **22.05.2023 KR 20230065644**

(71) Applicant: **LG Energy Solution, Ltd.
Seoul 07335 (KR)**

(72) Inventor: **SUNG, Yong Chul
Daejeon 34122 (KR)**

(74) Representative: **Plasseraud IP
104 Rue de Richelieu
CS92104
75080 Paris Cedex 02 (FR)**

(54) **DEVICE FOR ESTIMATING PARAMETER OF EQUIVALENT CIRCUIT MODEL FOR BATTERY AND OPERATING METHOD THEREFOR**

(57)    The parameter estimation apparatus according to an embodiment disclosed in this document may include an acquisition unit configured to acquire battery information comprising current, temperature, and state of charge of a battery unit, and a parameter estimation unit configured to estimate parameters of an equivalent circuit model for the battery unit based on the battery information, wherein the equivalent circuit model may include a first resistor, a second resistor connected in series with the first resistor, and a capacitor connected in parallel with the second resistor, and the parameter estimation unit may estimate the resistance of the first resistor among the parameters by inputting the current of the battery unit into an equation comprising at least one predetermined value corresponding to the temperature and the state of charge, with the current as a variable.

FIG.3

EP 4 700 401 A1

# Description

## [Technical Field]

CROSS-REFERENCE TO RELATED APPLICATION

This application claims priority to and the benefit of Korean Patent Application No. 10-2023-0065644 filed in the Korean Intellectual Property Office on May 22, 2023, the entire contents of which are incorporated herein by reference.

TECHNICAL FIELD

The embodiments disclosed in this document relate to an apparatus and method for estimating parameters of an equivalent circuit model for a battery.

## [Background Art]

Recently, research and development on secondary batteries have been actively conducted. Here, the secondary battery is a rechargeable battery and includes all of the conventional Ni/Cd batteries, Ni/MH batteries, and recent lithium ion batteries. Among the secondary batteries, Lithium ion batteries have an advantage of much higher energy density than the conventional Ni/Cd batteries and Ni/MH batteries. In addition, Lithium-ion batteries can be manufactured small and lightweight enough to be used as power sources for mobile devices and recently expand their usage range to power sources for electric vehicles, drawing attention as a next-generation energy storage medium.

To prevent overcharging and overdischarging of the battery, it is necessary to adjust the charging current and discharging current of the battery according to the state of charge (SOC) of the battery. However, the SOC of the battery is not directly measurable, but is estimated based on the terminal voltage and current of the battery. Therefore, for safer and more efficient control of the battery, accurately estimating the state of charge is crucial.

Generally, the estimation of the SOC for batteries widely relies on the use of Extended Kalman Filter (EKF)-based methods, and the Extended Kalman Filter includes a battery voltage estimation process based on an equivalent circuit model.

To estimate the battery voltage using the equivalent circuit model, values known as battery parameters such as R0, R1, C1 are required. Since these battery parameters can vary with the battery's temperature and SOC, methods have been employed to estimate the battery parameters based on the battery's temperature and SOC.

## [Disclosure]

## [Technical Problem]

However, the internal resistance of an actual battery can vary with changes in the magnitude of the current. In particular, given the pronounced variations in resistance with changes in the magnitude of current at low temperatures, it is necessary to consider the influence of current when determining the internal resistance of the battery to improve the accuracy of battery state estimation.

The embodiments disclosed in this document may provide a parameter estimation apparatus and method capable of estimating the parameters of an equivalent circuit model for a battery in consideration of not only temperature and SOC information but also current information.

The technical objects of the embodiments disclosed in this document are not limited to the aforesaid, and other objects not described herein with be clearly understood by those skilled in the art from the descriptions below.

## [Technical Solution]

A parameter estimation apparatus according to an embodiment disclosed in this document may include an acquisition unit configured to acquire battery information including current, temperature, and state of charge of a battery unit, and a parameter estimation unit configured to estimate parameters of an equivalent circuit model for the battery unit based on the battery information, wherein the equivalent circuit model may include a first resistor, a second resistor connected in series with the first resistor, and a capacitor connected in parallel with the second resistor, and the parameter estimation unit may estimate the resistance of the first resistor among the parameters by inputting the current of the battery unit into an equation including at least one predetermined value corresponding to the temperature and the state of charge, with the current as a variable.

In the parameter estimation apparatus according to an embodiment disclosed in this document, the at least one predetermined value may include a first predetermined value and a second predetermined value, and the equation is equation 1:

[equation 1]

$$Ro = a + b \cdot \log_{10}(I)$$

(in equation 1 Ro denotes the resistance of the first resistor, a denotes the first predetermined value, b denotes the second predetermined value, and I denotes the current of the battery unit.)

The parameter estimation apparatus according to an embodiment disclosed in this document may further include a correction unit configured to correct at least one of the first predetermined value or the second predetermined value by comparing the measured resistance of the first resistor of the battery unit and the estimated resistance.

The parameter estimation apparatus according to an embodiment disclosed in this document may further include a voltage estimation unit configured to estimate open circuit voltage (OCV) of the equivalent circuit model based on the state of charge of the battery unit.

In the parameter estimation apparatus according to an embodiment disclosed in this document, the voltage estimation unit may estimate the DC component voltage of the equivalent circuit model by multiplying the current and the resistance of the first resistor in the battery unit.

In the parameter estimation apparatus according to an embodiment disclosed in this document, the parameter estimation unit may estimate the resistance of the second resistor among the parameters based on the battery information, and the voltage estimation unit may estimate the AC component voltage of the equivalent circuit model based on the resistance of the second resistor.

In the parameter estimation apparatus according to an embodiment disclosed in this document, the voltage estimation unit may estimate the terminal voltage of the battery unit by summing up the OCV, the DC component voltage, and the AC component voltage.

A parameter estimation method according to an embodiment disclosed in this document may include acquiring battery information including current, temperature, and state of charge of a battery unit, and estimating parameters of an equivalent circuit model for the battery unit based on the battery information, wherein the equivalent circuit model may include a first resistor, a second resistor connected in series with the first resistor, and a capacitor connected in parallel with the second resistor, and the estimating of the parameters may include estimating the resistance of the first resistor among the parameters by inputting the current of the battery unit into an equation including at least one predetermined value corresponding to the temperature and the state of charge, with the current as a variable.

In the parameter estimation method according to an embodiment disclosed in this document, the at least one predetermined value may include a first predetermined value and a second predetermined value, and the equation is equation 1:

[equation 1]

$$Ro = a + b \cdot \log_{10}(I)$$

(in equation 1 Ro denotes the resistance of the first resistor, a denotes the first predetermined value, b denotes the second predetermined value, and I denotes the current of the battery unit.)

The parameter estimation apparatus according to an embodiment disclosed in this document may further include correcting at least one of the first predetermined value or the second predetermined value by comparing the measured resistance of the first resistor of the battery unit and the estimated resistance.

The parameter estimation apparatus according to an embodiment disclosed in this document may further include estimating open circuit voltage (OCV) of the equivalent circuit model based on the state of charge of the battery unit.

The parameter estimation apparatus according to an embodiment disclosed in this document may further include estimating the DC component voltage of the equivalent circuit model by multiplying the current and the resistance of the first resistor in the battery unit.

In the parameter estimation method according to an embodiment disclosed in this document, the estimating of the parameters further include estimating the resistance of the second resistor among the parameters based on the battery information, and estimating the AC component voltage of the equivalent circuit model based on the resistance of the second resistor.

The parameter estimation apparatus according to an embodiment disclosed in this document may further include estimating the terminal voltage of the battery unit by summing up the OCV, the DC component voltage, and the AC component voltage.

**[Advantageous Effects]**

According to the embodiments disclosed in this document, it is possible to improve the accuracy of battery state estimation by additionally considering the influence of current on the resistance value of the DC component resistance included in the equivalent circuit model of the battery.

In addition, various effects identified directly or indirectly through this document can be provided.

**[Description of Drawings]**

FIG. 1 is a diagram illustrating an exemplary equivalent circuit model of a battery;

FIG. 2 is a graph illustrating an example of how internal resistance varies with the current of the battery.

FIG. 3 is a block diagram of a parameter estimation apparatus according to an embodiment;

FIG. 4 is a diagram illustrating graphs comparing the internal resistance measured by the parameter estimation apparatus according to an embodiment with the measured resistances for a battery;

FIG. 5 is a flowchart illustrating the operation of a parameter estimation apparatus according to an embodiment; and

FIG. 6 is a flowchart illustrating the operation of a parameter estimation apparatus according to an embodiment.

**[Mode for Invention]**

Hereinafter, various embodiments of the present invention will be described with reference to the accompanying drawings. However, the description is not intended to limit the present invention to particular embodiments, and it should be construed as including various modifications, equivalents, and/or alternatives of the embodiments described herein.

Various embodiments disclosed in this document and terms used therein are not intended to limit the technical features described in this document to specific embodiments, and the disclosure should be construed as including various modifications, equivalents, and/or alternatives of the corresponding embodiments. In connection with the description of the drawings, like reference numbers may be used for like or related elements. The singular form of a noun corresponding to an item may include one item or a plurality of items unless the relevant context clearly dictates otherwise.

In this document, each of the phrases such as "A or B", "at least one of A and B", "at least one of A or B", "A, B or C", "at least one of A, B and C", and "at least one of A, B, or C" may include any of the items listed together in the corresponding phrase or any possible combination thereof. Terms such as "the first", "the second", "first", "second", "A", "B", "(a)", or "(b)" may be used simply to distinguish such components from other components and do not limit the corresponding components in other aspects (e.g., importance or order) unless otherwise stated specifically.

In this document, when it is mentioned that a (e.g., first) component is "connected", "coupled", "accessed", with or without the terms "functionally" or "communicatively", to another (e.g., second) component, it means that the component can be connected to the other component directly (e.g., wired), wirelessly, or via a third component. According to various embodiments, each component (e.g., module or program) of the components described above may include a single object or a plurality of objects, and some of the multiple objects may be separately disposed in other components.

According to various embodiments, one or more components or operations among the aforementioned components may be omitted, or one or more other components or operations may be added. Alternatively or additionally, a plurality of components (e.g., modules or programs) may be integrated into a single component. In this case, the integrated component may perform one or more functions of each of the plurality of components identically or similarly to those performed by the corresponding component of the plurality of components prior to the integration. According to various embodiments, operations performed by modules, programs, or other components are executed sequentially, in parallel, iteratively, or heuristically, or one or more of the operations are executed in a different order, omitted, or one or more other operations may be added.

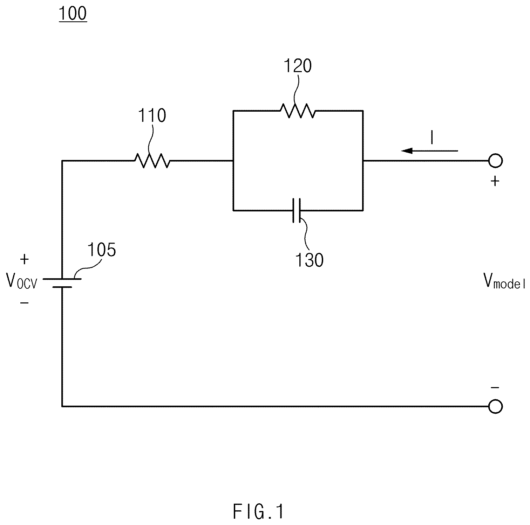

FIG. 1 is a diagram illustrating an exemplary equivalent circuit model of a battery.

With reference to FIG. 1, the equivalent circuit model 100 may include a voltage source 105, a first resistor 210, a second resistor 120, and a capacitor 130. The parameters of the equivalent circuit model 100 may include the resistance Ro of the first resistor 110, the resistance $R_1$ of the second resistor 120, and the capacitance C of the capacitor 130.

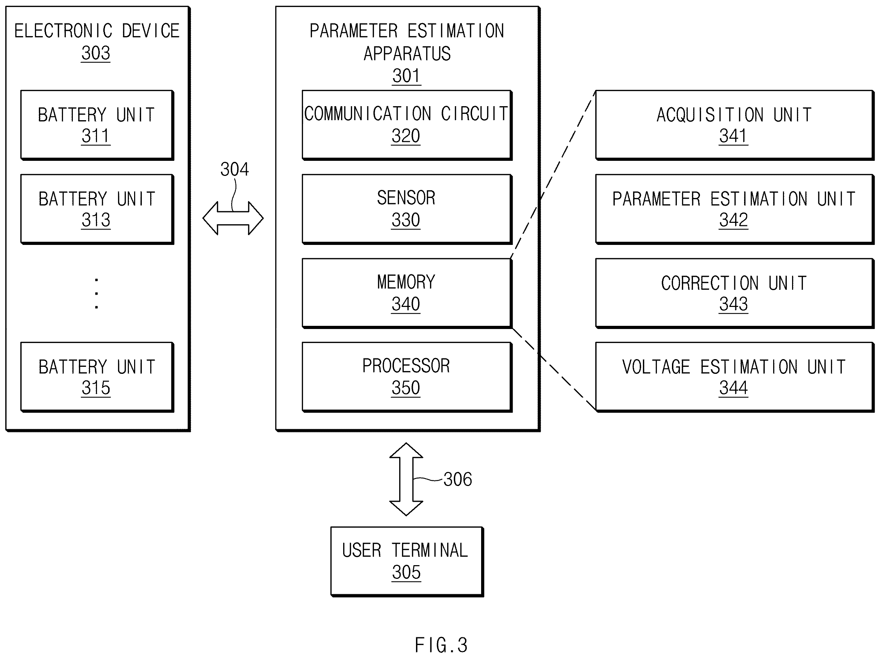

The voltage source 105 represents the open-circuit voltage $V_{OCV}$ of the battery, determined by the state of charge (SOC) and temperature of the battery. That is, the open-circuit voltage $V_{OCV}$ may be uniquely determined when the SOC and temperature are specified. The open-circuit voltage $V_{OCV}$ may be predefined for each SOC and temperature. That is, an OCV-SOC map defining the correlation between the SOC and temperature of the battery and open-circuit voltage ($V_{OCV}$) may be prestored in the memory 340 to be described later with reference to FIG. 3.

The first resistor 210 simulates short-term voltage fluctuations caused by the current flowing through the battery.

The second resistor 120 and capacitor 130 are connected in parallel to each other. As shown in the drawing, the second resistor 120 may be connected in series with the first resistor 110. The parallel connection circuit of the second resistor 120 and capacitor 130 may be referred to as an 'RC pair.' Unlike the first resistor 110, the second resistor 120 is connected in parallel to the capacitor 130. Therefore, the RC pair may simulate the polarization voltage generated during charging and discharging of the battery. That is, the parallel combination of the second resistor 120 and capacitor 130 is designed to simulate the excessive response of the battery.

The terminal voltage $V_{model}$ of the equivalent circuit model 100 may be calculated by summing the open-circuit voltage $V_{OCV}$, the voltage across the first resistor 110 (Vo), and the voltage across the second resistor 120 ($V_1$). Here, the voltage across the first resistor (Vo) is calculated by multiplying the current I flowing through the first resistor 110 by the resistance Ro, and the voltage across the second resistor $V_1$ is calculated by multiplying the current flowing through the second resistor 120 by the resistance $R_1$.

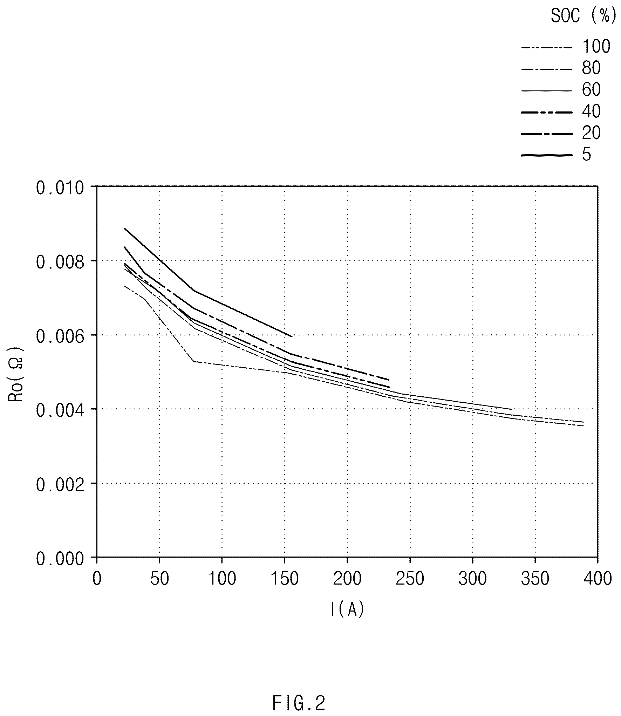

FIG. 2 is a graph illustrating an example of how internal resistance varies with the current of the battery. The graph in FIG. 2 may represent the internal resistance of the battery as a function of current under predetermined temperature conditions (e.g., -20°C) and predetermined SOC conditions (e.g., 100%, 80%, 60%, 40%, 20%, or 5%).

With reference to FIG. 2, it can be observed that the internal resistance Ro of the battery varies with the current I. In particular, the graph in FIG. 2 illustrates the variation in the internal resistance Ro of the battery under low-temperature conditions (e.g., -20°C), confirming a significant change in the internal resistance Ro with variations in the magnitude of current I at low temperatures. Therefore, it is necessary to consider the influence of current when determining the internal resistance of the battery equivalent circuit model.

FIG. 3 is a block diagram of a parameter estimation apparatus according to an embodiment.

With reference to FIG. 3, the parameter estimation apparatus 301 may be connected to an electronic device 303 and a user terminal 305 through a wired and/or wireless connection.

The operation of the parameter estimation apparatus 301 described below may be performed not only by a battery management system (BMS) in the vehicle but also by various devices such as servers, clouds, chargers, or charging-discharging equipment.

According to an embodiment, the connection 304 between the parameter estimation apparatus 301 and the electronic device 303 may be a communication link established through wired and/or wireless networks. In an embodiment, the wired network may be based on local area network (LAN) or power line communication. In an embodiment, the wireless network may be based on a short range communication network (e.g., Bluetooth, wireless fidelity (Wi-Fi), infrared data association (IrDA)) or a long-range communication network (e.g., cellular network encompassing 4G and 5G networks).

According to another embodiment, the connection 304 between the parameter estimation apparatus 301 and the electronic device 303 may be a connection established through an inter-device communication interface (e.g., bus, general purpose input and output (GPIO), serial peripheral interface (SPI), or mobile industry processor interface (MIPI)).

According to an embodiment, the connection 306 between the parameter estimation apparatus 301 and the user terminal 305 may be a communication link established through wired and/or wireless networks.

According to an embodiment, the electronic device 303 may be a mobile device (e.g., portable phone, laptop computer, smartphone, and smart pad), an electrified vehicle (e.g., electric vehicle (EV), hybrid EV (HEV), plug-in HEV (PHEV), and fuel cell EV (FCEV), an energy storage system (ESS), or a battery swapping system (BSS).

According to an embodiment, the electronic device 303 may include one or more battery units 311, 313, and 315. Each of the one or more battery units 311, 313, and 315 may be a battery cell, battery module, battery pack, or battery rack.

According to an embodiment, the user terminal 305 may be a mobile device (e.g., portable phone, laptop computer, smartphone, and smart pad) or a personal computer (PC). According to an embodiment, the parameter estimation apparatus 301 may provide information about the estimation results to the user terminal.

According to an embodiment, the parameter estimation apparatus 301 may include a communication circuit 320, a sensor 330, a memory 340, and a processor 350. According to an embodiment, the parameter estimation apparatus 301 shown in FIG. 3 may further include at least one additional component (e.g., a display, input device, or output device) other than the components illustrated in FIG. 3.

In an embodiment, the communication circuit 320 may establish a wired and/or wireless communication channel between the parameter estimation apparatus 301 and the electronic device 303 and/or user terminal 305 and exchange data with the electronic device 303 and/or the user terminal 305 through the established communication channel.

According to an embodiment, the sensor 330 may acquire values related to the state of the battery units 111, 113, and 115 of the electronic device 303. In an embodiment, the values related to the state may include one or more values representing the voltage, current, resistance, state of charge (SOC), state of health (SOH), or temperature of the battery units 111, 113, and 115, or any combination thereof. In the following, a value related to a state may be referred to as a state value.

According to an embodiment, the memory 340 may include volatile memory and/or non-volatile memory.

According to an embodiment, the memory 340 may store data used by at least one component of the parameter estimation apparatus 301 (e.g., processor 350). For example, the data may include software (or related instructions), input data, or output data. In an embodiment, the instructions may be executed by the processor 350 for the battery abnormality diagnosis apparatus 101 to perform operations defined by the instructions.

According to an embodiment, the memory 340 may include one or more software components (e.g., acquisition unit 341, parameter estimation unit 342, correction unit 343, and voltage estimation unit 344).

According to an embodiment, the processor 350 may include a central processing unit, an application processor, a graphic processing unit, a neural processing unit (NPU), an image signal processor, a sensor hub processor, or a communication processor.

According to an embodiment, the processor 350 may execute software (e.g., acquisition unit 341, parameter estimation unit 342, correction unit 343, and voltage estimation unit 344) to control at least one other component (e.g., hardware or software component) connected to the processor 350 in the parameter estimation apparatus 301 and perform various data processing or operations.

Hereinafter, a description is made of the method for the parameter estimation apparatus 301 to estimate parameters and/or voltage of an equivalent circuit model for a battery units 311, 313, or 315 through the acquisition unit 341, parameter estimation unit 342, correction unit 343, and voltage estimation unit 344.

According to an embodiment, the acquisition unit 341 may acquire battery information, including the current, temperature, and SOC of the battery units 311, 313, or 315. For example, the acquisition unit 341 may acquire the battery information from the electronic device 303 and/or an external server connected via wired and/or wireless networks using the communication circuit 320. As another example, the acquisition unit 341 may obtain the battery information by measuring the voltage, current, and/or temperature of the battery units 311, 313, or 315 through the sensor 330 and estimating the SOC based on the measured voltage, current, and/or temperature.

According to an embodiment, the parameter estimation unit 342 may estimate the parameters of an equivalent circuit model for the battery units 311, 313, or 315 based on the battery information acquired by the acquisition unit 341.

Hereinafter, for the convenience of explanation, the description is made under the assumption that the parameter estimation apparatus 301 estimates the parameters of the first-order RC equivalent circuit model 100 composed of the components (e.g., voltage source 105, first resistor 110, second resistor 120, and capacitor 130) as shown in FIG. 1. Here, the parameters may include the resistance Ro of the first resistor 110, the resistance $R_1$ of the second resistor 120, and the capacitance C of the capacitor 130. However, the subsequent explanation does not limit the parameter estimation apparatus 301 to estimating only the parameters of the first-order RC equivalent circuit model. That is, the parameter estimation apparatus 301 may be configured to estimate the parameters of second-order or higher RC equivalent circuit models.

According to an embodiment, the parameter estimation unit 342 may estimate the resistance Ro of the first resistor 110 among the parameters by inputting the current of the battery unit 311, 313, or 315 into a predetermined equation. According to an embodiment, the predetermined equation may include at least one predetermined value corresponding to the temperature and SOC of the battery units 311, 313, or 315 and may be an equation with the current as a variable. For example, the predetermined equation may be Equation 1.

[Equation 1]

$$Ro = a + b \cdot \log_{10}(I)$$

In Equation 1, Ro may denote the resistance of the first resistor 110, a may denote a first predetermined value included in at least one predetermined value, b may denote a second predetermined value included in at least one predetermined value, and I may denote the current of the battery unit 311, 313, or 315.

According to an embodiment, at least one predetermined value (e.g., the first predetermined value a and/or the second predetermined value b) may be uniquely determined when the temperature and SOC of the battery unit 311, 313, or 315, which are parameters to be estimated, are determined. That is, a table defining the correlation between the temperature, SOC, and at least one predetermined value for the battery unit 311, 313, or 315 may be prestored in the memory 340.

According to an embodiment, the correction unit 343 may correct at least one of the first predetermined value a or the second predetermined value b. According to an embodiment, the correction unit 343 may compare the measured resistance of the first resistor 110 with the estimated resistance Ro of the first resistor 110 obtained by the parameter estimation unit 342. The correction unit 343 may correct at least one of the first predetermined value a or the second predetermined value b based on the comparison results. For example, the correction unit 343 may correct at least one of the first predetermined value a or the second predetermined value b to minimize the difference between the measured resistance and the estimated resistance Ro.

According to an embodiment, the parameter estimation apparatus 301 may update the first predetermined value a and/or the second predetermined value b in the table defining the correlation between temperature, SOC, and at least one predetermined value with the value corrected by the correction unit 343 and store the updated table in the memory 340.

According to an embodiment, the voltage estimation unit 344 may estimate the voltage across at least one component of equivalent circuit model 100.

According to an embodiment, the voltage estimation unit 344 may estimate the open-circuit voltage (OCV) of the equivalent circuit model 100 based on the SOC of the battery unit 311, 313, or 315. For example, the voltage estimation unit 344 may refer to an OCV-SOC map prestored in the memory 340 to estimate the OCV as a voltage value corresponding to the SOC.

According to an embodiment, the voltage estimation unit 344 may estimate the DC component voltage of the equivalent circuit model 100. Here, the DC component voltage may refer to the voltage applied to the terminals of the first resistor 110. For example, the voltage estimation unit 344 may estimate the DC component voltage by multiplying the current flowing through the battery unit 311, 313, or 315 and the resistance Ro of the first resistor 110 estimated by the parameter estimation unit 342.

According to an embodiment, the voltage estimation unit 344 may estimate the AC component voltage of the equivalent circuit model 100. Here, the AC component voltage may refer to the voltage applied across the second resistor 120 and the capacitor 130. For example, the voltage estimation unit 344 may estimate the AC component voltage based on the resistance $R_1$ of the second resistor 120 estimated by the parameter estimation unit 342. In more detail, the voltage estimation unit 344 may estimate the AC component voltage by multiplying the current flowing through the second resistor 120 and the resistance $R_1$ of the second resistor 120 in the equivalent circuit model 100.

According to an embodiment, the voltage estimation unit 344 may estimate the terminal voltage of the battery unit 311, 313, or 315. According to an embodiment, the voltage estimation unit 344 may estimate the terminal voltage of the battery unit 311, 313, or 315 by summing the OCV, DC component voltage, and AC component voltage of the equivalent circuit model 100.

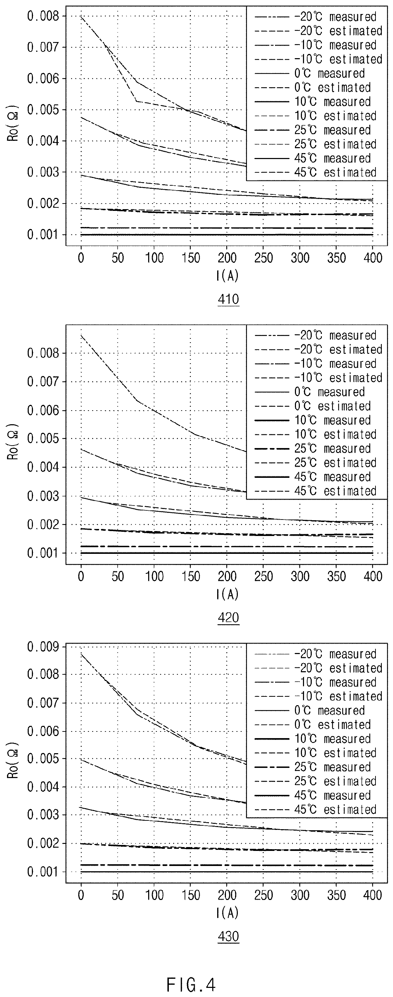

FIG. 4 is a diagram illustrating graphs comparing the internal resistance measured by the parameter estimation apparatus according to an embodiment with the measured resistances for a battery.

The graphs 410, 420, and 430 in FIG. 4 can represent the estimated internal resistance and measured internal resistance of the battery as a function of current under predetermined SOC conditions (e.g., graph 410 for 100%, graph 420 for 60%, and graph 430 for 20%) and predetermined temperatures (e.g., -20°C, -10°C, 0°C, 10°C, 25°C, or 45°C).

With reference to FIG. 4, it can be observed that the estimated internal resistance and measured internal resistance, determined by the parameter estimation apparatus 301, exhibit similar trends for each condition on the respective graphs 410, 420, or 430. That is, it can be confirmed that the battery internal resistance estimated by the parameter estimation unit 342 using Equation 1 exhibits similarity to the actual battery internal resistance.

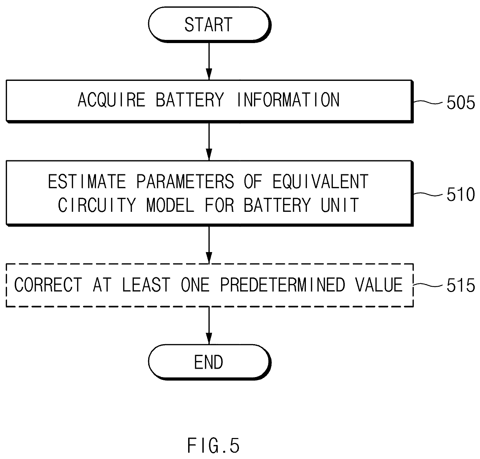

FIG. 5 is a flowchart illustrating the operation of a parameter estimation apparatus according to an embodiment. FIG. 5 may illustrate the operations of the parameter estimation apparatus 301 of FIG. 3, and descriptions may be made on the basis of the configuration (e.g., parameter estimation apparatus 301) in FIG. 3.

The embodiment shown in FIG. 5 is merely one embodiment, and the order of operations according to various embodiments of the present invention may be different from that shown in FIG. 5, and some operations shown in FIG. 5 may be omitted, changed in order, or merged. For example, operation 515 may be omitted in FIG. 5.

With reference to FIG. 5, the parameter estimation apparatus 301 may acquire battery information, including the current, temperature, and SOC of the battery units 311, 313, or 315 in operation 505. For example, the parameter estimation apparatus 301 may acquire the battery information from the external electronic device 303 and/or an external server connected via wired and/or wireless networks using the communication circuit 320. As another example, the parameter estimation apparatus 301 may obtain the battery information by measuring the voltage, current, and/or temperature of the battery units 311, 313, or 315 through the 330 and estimating the SOC based on the measured voltage, current, and/or temperature.

In operation 510, the parameter estimation apparatus 301 may estimate the parameters of an equivalent circuity model for the battery units 311, 313, or 315 based on the battery information acquired in operation 505.

According to an embodiment, the parameter estimation apparatus 301 may estimate the resistance Ro of the first resistor 110 among the parameters by inputting the current of the battery units 311, 313, or 315 into a predetermined equation. According to an embodiment, the predetermined equation may include at least one predetermined value corresponding to the temperature and SOC of the battery units 311, 313, or 315 and may be an equation with the current as a variable. For example, the predetermined equation may be Equation 1.

According to an embodiment, the at least one predetermined value (e.g., the first predetermined value a and/or the second predetermined value b) may be uniquely determined when the temperature and SOC of the target battery unit 311, 313, or 315 is determined. That is, a table defining the correlation between the temperature, SOC, and at least one predetermined value for the battery unit 311, 313, or 315 may be prestored in the memory 340.

In operation 515, the parameter estimation apparatus 301 may adjust at least one predetermined value (e.g., at least one of the first predetermined value a or the second predetermined value b). According to an embodiment, the parameter estimation apparatus 301 may compare the measured resistance of the first resistor 110 with the estimated resistance Ro of the first resistor 110 obtained by the parameter estimation unit 342. The parameter estimation apparatus 301 may correct at least one of the first predetermined value a or the second predetermined value b based on the comparison results. For example, the parameter estimation apparatus 301 may correct at least one of the first predetermined value a or the second predetermined value b to minimize the difference between the measured resistance and the estimated resistance Ro.

According to an embodiment, the parameter estimation apparatus 301 may update the first predetermined value a and/or the second predetermined value b in the table defining the correlation between temperature, SOC, and at least one predetermined value with the value corrected by the correction unit 343 and store the updated table in the memory 340.

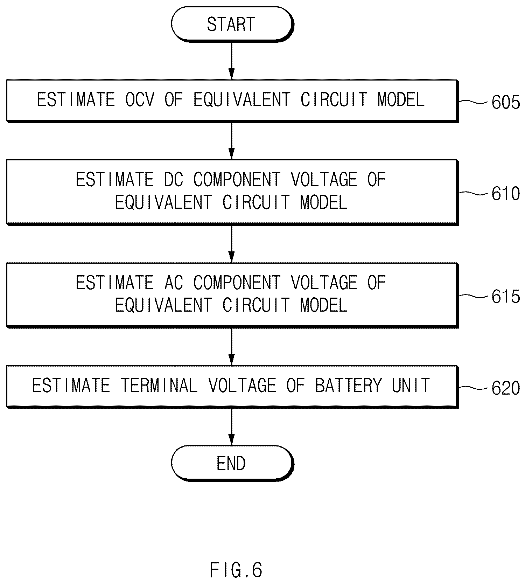

FIG. 6 is a flowchart illustrating the operation of a parameter estimation apparatus according to an embodiment. FIG. 6 may illustrate the operations of the parameter estimation apparatus 301 of FIG. 3, and descriptions may be made on the basis of the configuration (e.g., data processing apparatus 301) in FIG. 3.

The embodiment shown in FIG. 6 is merely one embodiment, and the order of operations according to various embodiments of the present invention may be different from that shown in FIG. 6, and some operations shown in FIG. 6 may be omitted, changed in order, or merged.

With reference to FIG. 6, the parameter estimation apparatus 301 may estimate the open-circuit voltage (OCV) of the equivalent circuit model 100 based on the SOC of the battery unit 311, 313, or 315 in operation 605. For example, the parameter estimation apparatus 301 may refer to an OCV-SOC map prestored in the memory 340 to estimate the OCV as a voltage value corresponding to the SOC.

In operation 610, the parameter estimation apparatus 301 may estimate the DC component voltage of the equivalent circuit model 100. Here, the DC component voltage may refer to the voltage applied to the terminals of the first resistor 110. For example, the parameter estimation apparatus 301 may estimate the DC component voltage by multiplying the current flowing through the battery unit 311, 313, or 315 and the estimate resistance Ro of the first resistor 110 estimated in operation 510.

In operation 615, the parameter estimation apparatus 301 may estimate the AC component voltage of the equivalent circuit model 100. Here, the AC component voltage may refer to the voltage applied across the second resistor 120 and the capacitor 130. For example, the voltage estimation apparatus 301 may estimate the AC component voltage based on the resistance $R_1$ of the second resistor 120 estimated in operation 510 of FIG. 5. In more detail, the parameter estimation apparatus 301 may estimate the AC component voltage by multiplying the current value flowing through the second resistor 120 and the resistance $R_1$ of the second resistor 120 in the equivalent circuit model 100.

In operation 620, the parameter estimation apparatus 301 may estimate the terminal voltage of the battery unit 311, 313, or 315. According to an embodiment, the parameter estimation apparatus 301 may estimate the terminal voltage of the battery unit 311, 313, or 315 by summing the OCV estimated in operation 605, the DC component voltage estimated in operation 610, and the AC component voltage estimated in operation 615.

Also, the terms such as "comprise", "include", or "have" used above implies that the corresponding component may be present unless otherwise stated specifically, and thus it should be construed as being able to further include other components rather than exclude other components. Unless otherwise defined herein, all terms including technical or scientific terms used herein have the same meanings as commonly understood by those skilled in the art to which the present invention belongs. It will be further understood that terms, such as those defined in commonly used dictionaries, should be interpreted as having a meaning that is consistent with their meaning in the context of the relevant art and should not be interpreted in an idealized or overly formal sense unless expressly so defined herein.

**Claims**

**1.** A parameter estimation apparatus comprising:

an acquisition unit configured to acquire battery information comprising current, temperature, and state of charge of a battery unit; and
a parameter estimation unit configured to estimate parameters of an equivalent circuit model for the battery unit based on the battery information,
wherein the equivalent circuit model comprises a first resistor, a second resistor connected in series with the first resistor, and a capacitor connected in parallel with the second resistor, and the parameter estimation unit estimates the resistance of the first resistor among the parameters by inputting the current of the battery unit into an equation comprising at least one predetermined value corresponding to the temperature and the state of charge, with the current as a variable.

**2.** The parameter estimation apparatus of claim 1, wherein the at least one predetermined value comprises a first predetermined value and a second predetermined value, and the equation is equation 1:
[equation 1]

$$Ro = a + b \cdot \log_{10}(I)$$

(in equation 1 Ro denotes the resistance of the first resistor, a denotes the first predetermined value, b denotes the second predetermined value, and I denotes the current of the battery unit.)

**3.** The parameter estimation apparatus of claim 2, further comprising a correction unit configured to correct at least one of the first predetermined value or the second predetermined value by comparing the measured resistance of the first resistor of the battery unit and the estimated resistance.

**4.** The parameter estimation apparatus of claim 1, further comprising a voltage estimation unit configured to estimate open circuit voltage (OCV) of the equivalent circuit model based on the state of charge of the battery unit.

**5.** The parameter estimation apparatus of claim 4, wherein the voltage estimation unit estimates the DC component voltage of the equivalent circuit model by multiplying the current and the resistance of the first resistor in the battery unit.

**6.** The parameter estimation apparatus of claim 5, wherein the parameter estimation unit estimates the resistance of the second resistor among the parameters based on the battery information, and the voltage estimation unit estimates the AC component voltage of the equivalent circuit model based on the resistance of the second resistor.

7. The parameter estimation apparatus of claim 6, wherein the voltage estimation unit estimates the terminal voltage of the battery unit by summing up the OCV, the DC component voltage, and the AC component voltage.

8. A parameter estimation method comprising:

acquiring battery information comprising current, temperature, and state of charge of a battery unit; and
estimating parameters of an equivalent circuit model for the battery unit based on the battery information,
wherein the equivalent circuit model comprises a first resistor, a second resistor connected in series with the first resistor, and a capacitor connected in parallel with the second resistor, and the estimating of the parameters comprises estimating the resistance of the first resistor among the parameters by inputting the current of the battery unit into an equation comprising at least one predetermined value corresponding to the temperature and the state of charge, with the current as a variable.

9. The parameter estimation method of claim 8, wherein the at least one predetermined value comprises a first predetermined value and a second predetermined value, and the equation is equation 1:
[equation 1]

$$Ro = a + b \cdot \log_{10}(I)$$

(in equation 1 Ro denotes the resistance of the first resistor, a denotes the first predetermined value, b denotes the second predetermined value, and I denotes the current of the battery unit.)

10. The parameter estimation method of claim 9, further comprising correcting at least one of the first predetermined value or the second predetermined value by comparing the measured resistance of the first resistor of the battery unit and the estimated resistance.

11. The parameter estimation method of claim 8, further comprising estimating open circuit voltage (OCV) of the equivalent circuit model based on the state of charge of the battery unit.

12. The parameter estimation method of claim 11, further comprising estimating the DC component voltage of the equivalent circuit model by multiplying the current and the resistance of the first resistor in the battery unit.

13. The parameter estimation method of claim 12, wherein the estimating of the parameters further comprises:

estimating the resistance of the second resistor among the parameters based on the battery information; and
estimating the AC component voltage of the equivalent circuit model based on the resistance of the second resistor.

14. The parameter estimation method of claim 13, further comprising estimating the terminal voltage of the battery unit by summing up the OCV, the DC component voltage, and the AC component voltage.

100

120

110

I

+

105

$V_{OCV}$

+

−

130

$V_{model}$

−

FIG.1

FIG.2

FIG.3

410

420

430

FIG.4

START

ACQUIRE BATTERY INFORMATION ⌇505

ESTIMATE PARAMETERS OF EQUIVALENT
CIRCUITY MODEL FOR BATTERY UNIT ⌇510

CORRECT AT LEAST ONE PREDETERMINED VALUE ⌇515

END

FIG.5

START

ESTIMATE OCV OF EQUIVALENT CIRCUIT MODEL  —605

ESTIMATE DC COMPONENT VOLTAGE OF
EQUIVALENT CIRCUIT MODEL  —610

ESTIMATE AC COMPONENT VOLTAGE OF
EQUIVALENT CIRCUIT MODEL  —615

ESTIMATE TERMINAL VOLTAGE OF BATTERY UNIT  —620

END

FIG.6

## INTERNATIONAL SEARCH REPORT

| International application No. |
|---|
| **PCT/KR2024/000428** |

### A. CLASSIFICATION OF SUBJECT MATTER

**G01R 31/367**(2019.01)i; **G01R 31/389**(2019.01)i; **G01R 31/382**(2019.01)i; **G01R 31/374**(2019.01)i; **G01R 31/36**(2006.01)i

According to International Patent Classification (IPC) or to both national classification and IPC

### B. FIELDS SEARCHED

Minimum documentation searched (classification system followed by classification symbols)

G01R 31/367(2019.01); G01R 31/36(2006.01); G01R 31/392(2019.01); H01M 10/42(2006.01); H01M 10/44(2006.01); H01M 10/48(2006.01); H02J 7/04(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 전지(battery), 등가회로(equivalent circuit), 저항(resistor), 커패시터(capacitor굴), 파라미터(parameter), 전압(voltage), 온도(temperature)

### C. DOCUMENTS CONSIDERED TO BE RELEVANT

| Category* | Citation of document, with indication, where appropriate, of the relevant passages | Relevant to claim No. |
|---|---|---|
| X | KR 10-2019-0050169 A (LG CHEM, LTD.) 10 May 2019 (2019-05-10)<br>See paragraphs [0036]-[0073], claim 1 and figure 3. | 1,4-6,8,11-13 |
| Y | | 7,14 |
| A | | 2-3,9-10 |
| Y | KR 10-2019-0093410 A (LG CHEM, LTD.) 09 August 2019 (2019-08-09)<br>See claim 1. | 7,14 |
| A | KR 10-2017-0022758 A (LG CHEM, LTD.) 02 March 2017 (2017-03-02)<br>See entire document. | 1-14 |
| A | KR 10-2022-0058250 A (LG ENERGY SOLUTION, LTD.) 09 May 2022 (2022-05-09)<br>See claims 1-10. | 1-14 |

☑ Further documents are listed in the continuation of Box C.    ☑ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **12 April 2024** | **12 April 2024** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

**INTERNATIONAL SEARCH REPORT**

International application No.

**PCT/KR2024/000428**

| C. | DOCUMENTS CONSIDERED TO BE RELEVANT | |
|---|---|---|
| Category* | Citation of document, with indication, where appropriate, of the relevant passages | Relevant to claim No. |
| A | US 2015-0380774 A1 (SEIKO INSTRUMENTS INC.) 31 December 2015 (2015-12-31)<br>See entire document. | 1-14 |

Form PCT/ISA/210 (second sheet) (July 2022)

**INTERNATIONAL SEARCH REPORT**
Information on patent family members

International application No.

**PCT/KR2024/000428**

| Patent document cited in search report | | | Publication date (day/month/year) | Patent family member(s) | | | Publication date (day/month/year) |
|---|---|---|---|---|---|---|---|
| KR | 10-2019-0050169 | A | 10 May 2019 | CN | 110573892 | A | 13 December 2019 |
| | | | | CN | 110573892 | B | 22 October 2021 |
| | | | | EP | 3627167 | A1 | 25 March 2020 |
| | | | | EP | 3627167 | A4 | 29 July 2020 |
| | | | | EP | 3627167 | B1 | 26 April 2023 |
| | | | | JP | 2020-521947 | A | 27 July 2020 |
| | | | | JP | 6848143 | B2 | 24 March 2021 |
| | | | | KR | 10-2194844 | B1 | 23 December 2020 |
| | | | | US | 11119157 | B2 | 14 September 2021 |
| | | | | US | 2021-0165046 | A1 | 03 June 2021 |
| | | | | WO | 2019-088492 | A1 | 09 May 2019 |
| KR | 10-2019-0093410 | A | 09 August 2019 | CN | 110741268 | A | 31 January 2020 |
| | | | | CN | 110741268 | B | 29 October 2021 |
| | | | | EP | 3712628 | A1 | 23 September 2020 |
| | | | | EP | 3712628 | A4 | 17 March 2021 |
| | | | | JP | 2020-524875 | A | 20 August 2020 |
| | | | | JP | 6859585 | B2 | 14 April 2021 |
| | | | | KR | 10-2373449 | B1 | 10 March 2022 |
| | | | | US | 11366169 | B2 | 21 June 2022 |
| | | | | US | 2020-0209315 | A1 | 02 July 2020 |
| | | | | WO | 2019-151674 | A1 | 08 August 2019 |
| KR | 10-2017-0022758 | A | 02 March 2017 | CN | 107408827 | A | 28 November 2017 |
| | | | | CN | 107408827 | B | 21 April 2020 |
| | | | | EP | 3252918 | A1 | 06 December 2017 |
| | | | | EP | 3252918 | A4 | 13 June 2018 |
| | | | | EP | 3252918 | B1 | 02 October 2019 |
| | | | | JP | 2018-523891 | A | 23 August 2018 |
| | | | | JP | 6454817 | B2 | 16 January 2019 |
| | | | | KR | 10-1925002 | B1 | 04 December 2018 |
| | | | | US | 10333180 | B2 | 25 June 2019 |
| | | | | US | 2018-0069272 | A1 | 08 March 2018 |
| | | | | WO | 2017-034275 | A1 | 02 March 2017 |
| KR | 10-2022-0058250 | A | 09 May 2022 | CN | 116368391 | A | 30 June 2023 |
| | | | | EP | 4206712 | A1 | 05 July 2023 |
| | | | | JP | 2023-543747 | A | 18 October 2023 |
| | | | | US | 2024-0012065 | A1 | 11 January 2024 |
| | | | | WO | 2022-092621 | A1 | 05 May 2022 |
| US | 2015-0380774 | A1 | 31 December 2015 | CN | 105203958 | A | 30 December 2015 |
| | | | | CN | 105203958 | B | 12 March 2019 |
| | | | | JP | 2016-011916 | A | 21 January 2016 |
| | | | | JP | 6386816 | B2 | 05 September 2018 |
| | | | | KR | 10-2016-0002378 | A | 07 January 2016 |
| | | | | TW | 201606329 | A | 16 February 2016 |
| | | | | TW | I586981 | B | 11 June 2017 |
| | | | | US | 9812743 | B2 | 07 November 2017 |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020230065644